# EUROPÄISCHE PATENTSCHRIFT

(11) **EP 3 559 684 B1**
(45) Veröffentlichungstag und Bekanntmachung des Hinweises auf die Patenterteilung: **08.03.2023**
(21) Anmeldenummer: 17808471.1
(22) Anmeldetag: 04.12.2017
(51) Int. Cl.: G01R 19/145, H02H 5/12, G08B 21/02

(54) **VORRICHTUNG UND VERFAHREN ZUM SCHUTZ EINER PERSON VOR EINEM ELEKTRISCHEN SIGNAL**
APPARATUS AND METHOD FOR PROTECTING A PERSON FROM AN ELECTRICAL SIGNAL
DISPOSITIF ET PROCÉDÉ PERMETTANT DE PROTÉGER UNE PERSONNE CONTRE UN SIGNAL ÉLECTRIQUE

(30) Priorität: 23.12.2016 AT 511812016
(43) Veröffentlichungstag der Anmeldung: 30.10.2019
(60) Teilanmeldung: 22207580.6
(73) Patentinhaber: Adaptive Regelsysteme Gesellschaft mbH, 5020 Salzburg (AT)
(72) Erfinder: DE VILLIERS, Wernich, 6850 Dornbirn (AT); KLAPPER, Ulrich, 6830 Rankweil (AT)
(74) Vertreter: Banzer, Hans-Jörg
(86) Internationale Anmeldenummer: PCT/EP2017/081366
(87) Internationale Veröffentlichungsnummer: WO 2018/114304

(56) Entgegenhaltungen:
- WO-A1-2016/014260
- DE-A1- 3 903 025
- DE-A1- 4 438 063
- FR-A1- 2 786 068
- US-A1- 2003 214 408
- US-A1- 2004 080 320

## Beschreibung

Gemäß einer Ausführungsform wird eine Vorrichtung zum Schutz einer Person vor einem elektrischen Signal sowie ein zugehöriges Verfahren offenbart.

Die stetig steigende Nachfrage nach elektrizitätsbasierten Geräten und Systemlösungen stellt gerade in der Bereitstellung der hierfür erforderlichen energetischen Ressourcen eine große Herausforderung dar. Dabei beschränken sich die damit in Verbindung stehenden Herausforderungen jedoch nicht auf die Bereitstellung von Energie in einer für einen Konsumenten nutzbaren, in vielen Fällen elektrischen Form. Vielmehr betreffen diese auch die Speicherung dieser nutzbaren Energieform zur Nutzung zu einem gegebenen Zeitpunkt sowie den Energietransport zu einem für den Energiekonsumenten wünschenswerten Ort.

Basierend auf den Herausforderungen im Bereich der Energiespeicherung sowie des Energietransports hat sich die Energietechnik als eigenständiges Tätigkeitsfels zunehmend etabliert. Gerade aufgrund der zunehmenden Förderung von alternativen Energiequellen, welche räumlich lokal sowie an aktuelle Wetterkonstellationen gebunden sind, wird das Tätigkeitsfeld Energietechnik voraussichtlich auch zukünftig weiter an Bedeutung gewinnen, sodass es einer hohen Anzahl zuverlässig arbeitender Energiespeicher- und Transportmechanismen bedarf.

Im Bereich der Energietechnik bedarf es insbesondere der Bereitstellung entsprechender Transportanlagen, sogenannter Hochspannungstrassen, deren Wartung und Instandhaltung es in immer widerkehrenden Abständen bedarf. Dabei ist es erforderlich, dass sich ein Energietechniker zur Ausübung seiner Tätigkeit im laufenden Betrieb dieser Hochspannungsbeförderungseinrichtungen unmittelbar in deren Umgebung aufhält. Der Hochspannungsbeförderungseinrichtungen ist dabei jedoch eine für den Energietechniker hohe Gefahrenquelle beizumessen, da für diesen im Falle eines unbeabsichtigten Kontaktes mit der Hochspannungsbeförderungseinrichtung oder zugehörigen Sekundäreinrichtungen Lebensgefahr besteht. Es besteht daher ein großer Bedarf an einer Schutzvorrichtung für eine Person, welche sich in der Umgebung einer Hochspannungsanlage aufhält, die die zu schützende Person im Falle eines unbeabsichtigten Kontakts mit der Hochspannungsanlage vor einem entsprechenden elektrischen Signal schützt. Ein Beispiel einer solchen Schutzvorrichtung ist aus j DE 39 03 025 A1 bekannt.

Des Weiteren gibt es auch außerhalb von energietechnischen Anwendungen den Bedarf, Personen, welche sich in Bereichen befinden, bei denen eine Gefährdung durch elektrische Spannungen nicht völlig ausgeschlossen werden kann, bestmöglich zu schützen. Dies können beispielsweise Personen in einem Prüffeld von elektrisch betriebenen Maschinen oder Elektriker in einem Industrie- oder Haushaltsumfeld sein.

Gemäß einer Ausführungsform liegt daher die Aufgabe zugrunde, eine Vorrichtung zum Schutz einer Person vor einem elektrischen Signal bereitzustellen, welche dazu eingerichtet ist, einer zu schützenden Person einen verbesserten Schutz gegenüber einem einwirkenden elektrischen Signal eines elektrisch aktivierbaren Objekts zu ermöglichen.

Gemäß einer weiteren Ausführungsform liegt daher die Aufgabe zugrunde, ein Verfahren zum Schutz einer Person vor einem elektrischen Signal bereitzustellen, welches eine zu schützenden Person besser gegenüber einem einwirkenden elektrischen Signal eines elektrisch aktivierbaren Objekts schützt.

Diese Aufgaben werden gemäß einer Ausführungsform durch eine Vorrichtung zum Schutz einer Person vor einem elektrischen Signal gemäß Anspruch 1 sowie gemäß einer weiteren Ausführungsform durch ein Verfahren zum Schutz einer Person vor einem elektrischen Signal mit den Merkmalen des Anspruchs gelöst. Weitere diese Ausführungsformen betreffende Ausgestaltungen werden in den abhängigen Ansprüchen beansprucht.

Gemäß einer Ausführungsform weist die Vorrichtung zum Schutz einer Person vor einem elektrischen Signal eine von der zu schützenden Person tragbare Sensoreinrichtung auf, welche mindestens einen Sensor aufweist, der zum Ermitteln einer Größe eingerichtet ist, die für ein auf die Person einwirkendes elektrisches Signal eines elektrisch aktivierbaren Objekts repräsentativ ist, sowie eine Schalteinrichtung, welche zum Annehmen eines ersten Betriebszustandes und eines zweiten Betriebszustandes eingerichtet ist, wobei der erste Betriebszustand die Übertragung des elektrischen Signals des elektrisch aktivierbaren Objekts auf die zu schützende Person ermöglicht und der zweite Betriebszustand die Übertragung des elektrischen Signals des elektrisch aktivierbaren Objekts auf die zu schützende Person nicht ermöglicht. Gemäß dieser Ausführungsform weist die Vorrichtung ferner eine Steuereinrichtung auf, welche basierend auf einem Ausgangssignal des mindestens einen Sensors die Schalteinrichtung ansteuert, so dass die Schalteinrichtung abhängig von dem Ausgangssignal des mindestens einen Sensors selektiv den ersten Betriebszustand oder den zweiten Betriebszustand annimmt. Der mindestens eine Sensor ist ein biometrischer Sensor zum Ermitteln einer biometrischen Größe der zu schützenden Person in Abhängigkeit von dem auf die Person einwirkenden elektrischen Signal.

Auf diese Weise kann das Vorliegen einer Gefahrensituation auf Basis der auf den menschlichen Körper einwirkenden elektrischen Signale ermittelt werden.

Hiernach wird einerseits der Ansatz verfolgt, für eine sich in einer elektrischen Gefährdungssituation befindende Person einen verbesserten, auf die Gefährdungssituation ausgerichteten Schutz bereitzustellen. Andererseits wird durch die Bereitstellung einer derartigen Vorrichtung das Annehmen des zweiten Betriebszustandes, welcher unter Umständen gegenüber dem Annehmen des ersten Betriebszustandes mit einem höheren Aufwand verbunden sein kann oder mit anderen unerwünschten Unannehmlichkeiten einhergehen kann, auf elektrische Gefährdungssituationen begrenzt, in welchen zum Schutze der zu schützenden Person ein Annehmen des zweiten Betriebszustandes unvermeidlich ist. Die Vorrichtung sieht hiernach ferner eine besonders einfache Ausgestaltung vor, welche mit technisch einfachen Mitteln realisierbar ist und somit mit möglichst geringen Beeinträchtigungen der zu schützenden Person beim Vollziehen ihrer vorgesehenen Tätigkeit einhergeht.

Gemäß einer weiteren Ausführungsform weist das Verfahren zum Schutz einer Person vor einem elektrischen Signal die Schritte a) Ermitteln einer Größe, die für ein auf die zu schützende Person einwirkendes elektrisches Signal eines elektrisch aktivierbaren Objekts repräsentativ ist, mit Hilfe mindestens eines Sensors einer von der zu schützenden Person getragenen Sensoreinrichtung, und b) Ansteuern einer Schalteinrichtung mit Hilfe einer Steuereinrichtung basierend auf einem Ausgangssignal des mindestens einen Sensors derart, dass die Schalteinrichtung abhängig von dem Ausgangssignal des mindestens einen Sensors selektiv einen ersten Betriebszustand oder einen zweiten Betriebszustand annimmt, wobei der erste Betriebszustand die Übertragung des elektrischen Signals des elektrisch aktivierbaren Objekts auf die zu schützende Person ermöglicht und der zweite Betriebszustand die Übertragung des elektrischen Signals des elektrisch aktivierbaren Objekts auf die zu schützende Person nicht ermöglicht, auf.

Hiernach wird einerseits der Ansatz verfolgt, eine sich in einer elektrischen Gefährdungssituation befindende Person besser und spezifischer gegen eine gegenwärtige Gefährdungssituation zu schützen. Andererseits beschränkt das Verfahren das Annehmen des zweiten Betriebszustandes, welcher unter Umständen gegenüber dem Annehmen des ersten Betriebszustandes mit einem höheren Aufwand verbunden sein kann oder mit anderen unerwünschten Unannehmlichkeiten einhergehen kann, auf elektrische Gefährdungssituationen, in welchen zum Schutze der zu schützenden Person ein Annehmen des zweiten Betriebszustandes unvermeidlich ist. Das Verfahren wird ferner mit technisch möglichst einfachen Mitteln durchgeführt und beeinträchtigt daher die zu schützenden Person beim Vollziehen ihrer vorgesehenen Tätigkeit in einem möglichst geringen Ausmaß.

Unter einer zu schützenden Person gemäß einer Ausführungsform kann eine Person verstanden werden, deren Schutz bezweckt ist und/oder erstrebenswert ist. Dabei kann der Schutz dieser Person unter Heranziehen der Vorrichtung und/oder des Verfahrens gemäß einer Ausführungsform vorgesehen sein.

Unter einem elektrisch aktivierbaren Objekt gemäß einer Ausführungsform kann ein beliebiges Objekt verstanden werden, dessen aktivierter Zustand bei Einwirkung eines beliebigen elektrischen Signals herbeigeführt werden kann. Dabei kann sich der aktivierte Zustand des aktivierbaren Objekts von einem Zustand des aktivierbaren Objekts ohne Einwirkung eines elektrischen Signals unterscheiden. Das elektrisch aktivierbare Objekt kann ein elektrisch leitfähiges Objekt sein. Das elektrisch aktivierbare Objekt kann dazu eingerichtet sein, mit einer elektrischen Spannungsquelle eine elektrische Verbindung auszubilden.

Unter einem Betriebszustand gemäß einer Ausführungsform kann ein Zustand verstanden werden, welchen eine Vorrichtung oder Einrichtung bei ihrer Inbetriebnahme annehmen kann. Diese Inbetriebnahme kann sich auf die durch die Vorrichtung oder die Einrichtung bezweckte Tätigkeit beziehen. Die Vorrichtung oder Einrichtung kann mehrere voneinander unterschiedliche Betriebszustände vorsehen. Mindestens ein Betriebszustand der Vorrichtung oder Einrichtung kann sich von einem Zustand, bei welchem die Vorrichtung oder Einrichtung nicht in Betrieb ist, unterscheiden.

Gemäß einem Beispiel der Vorrichtung ist das elektrisch aktivierbare Objekt eine Komponente einer energietechnischen Einrichtung, insbesondere einer Schaltanlage.

Auf diese Weise kann ein Energietechniker beim Vollziehen seiner Arbeitstätigkeit, welche häufig in kurzer Distanz mit Komponenten einer energietechnischen Einrichtung zu vollziehen ist, vor Einwirkungen dieser Einrichtung, beispielsweise auf Basis von elektrischen Hochspannungssignalen, geschützt werden.

Gemäß einem Beispiel der Vorrichtung ist diese derart ausgestaltet, dass in dem zweiten Betriebszustand ein elektrisches Kurzschließen durch die Schalteinrichtung erfolgt, um die Übertragung des elektrischen Signals auf die zu schützende Person zu unterbinden. Gemäß einem Beispiel der Vorrichtung ist diese derart ausgestaltet, dass in dem zweiten Betriebszustand durch die Schalteinrichtung eine elektrische Verbindung unterbrochen wird, um die Übertragung des elektrischen Signals auf die zu schützende Person zu unterbinden.

Insbesondere kann der zweite Betriebszustand auch dadurch erreicht werden, dass die Vorrichtung sich eines bestehenden Systems mit Not-Ausschaltung zum Schutz der Person bedient.

Auf diese Weise kann eine Ausgestaltung der Schalteinrichtung für die Schutzvorrichtung der schützenden Person ermöglicht werden, welche mit möglichst einfachen technischen Mitteln und auf eine möglichst zuverlässige Weise eine zu schützende Person vor einer Gefährdungssituation schützen kann.

Gemäß einem Beispiel der Vorrichtung ist die zu ermittelnde Größe des mindestens einen Sensors eine an der zu schützenden Person anliegende elektrische Spannung oder ein elektrischer Strom, welcher durch die zu schützende Person fließt.

Auf diese Weise kann eine gegenwärtig unter Einwirkung von Elektrizität stehende, zu schützende Person vor einem Unfall oder einer Schädigung durch Einwirkung elektrischer Signale auf deren Körper bewahrt werden oder zumindest die Auswirklungen durch einen Stromfluss minimiert werden.

Gemäß einem Beispiel der Vorrichtung weist der mindestens eine Sensor eine Rogowski-Spule auf.

Auf diese Weise kann ein Strommessverfahren bereitgestellt werden, welches einfach den Stromfluss durch eine oder mehrere Extremitäten der zu schützenden Person ermittelt.

Gemäß einer Ausführungsform der Vorrichtung beinhaltet die zu ermittelnde biometrische Größe den Pulsschlag der zu schützenden Person.

Auf diese Weise kann das Vorliegen einer Gefahrensituation auf Basis der Veränderung des Pulsschlags bei Beeinträchtigung durch auf die Person einwirkenden elektrischen Signale ermittelt werden.

Gemäß einer Ausführungsform der Vorrichtung ist eine erste drahtlose Verbindung zwischen dem mindestens einen ersten Sensor und der Steuereinrichtung ermöglicht. Gemäß einer Ausführungsform der Vorrichtung ist eine zweite drahtlose Verbindung zwischen der Steuereinrichtung und der Schalteinrichtung ermöglicht.

Auf diese Weise kann eine Signalübertragung zwischen den jeweiligen Komponenten der Vorrichtung ermöglicht werden, ohne dass es einen leitenden Kontakt zwischen den entsprechenden Komponenten bedarf. Dies ermöglicht bei der Anordnung der Vorrichtungskomponenten eine flexiblere räumliche Ausgestaltung.

Gemäß einer weiteren Ausführungsform der Vorrichtung weist diese eine Warnsignaleinrichtung auf, welche zum Ausgeben eines Warnsignals im Falle einer Störung der ersten drahtlosen Verbindung und/oder der zweiten drahtlosen Verbindung eingerichtet ist. Auf diese Weise kann eine Gefährdungssituation einer zu schützenden Person aufgrund mangelnder Funktionalität der Vorrichtung durch ein Warnsignal, beispielsweise ein akustisches Signal, kenntlich gemacht werden. Die zu schützende Person kann hierauf basierend entsprechende Schlussfolgerungen ziehen, beispielsweise eine Unterbrechung ihrer in einer Gefährdungsumgebung stattfinden Tätigkeit und/oder den Austausch der von ihr verwendeten Schutzvorrichtung.

Gemäß einer Ausführungsform der Vorrichtung ist diese dazu eingerichtet, dass die Schalteinrichtung im Falle einer Störung der ersten drahtlosen Verbindung und/oder der zweiten drahtlosen Verbindung den zweiten Betriebszustand annimmt.

Auf diese Weise kann bei Vorliegen einer Störung in der Funktionalität die Vorrichtung fortwährend einen Zustand annehmen, in welchem die zu schützende Person gegen eine Gefährdung geschützt ist, sodass Mängel in der Funktionalität kompensiert werden können.

Gemäß einem Beispiel der Vorrichtung ist die erste drahtlose Verbindung und/oder die zweite drahtlose Verbindung eine Funkverbindung.

Auf diese Weise kann eine besonders einfache und zuverlässige drahtlose Signalübertragung ermöglicht werden.

Gemäß einer Ausführungsform der Vorrichtung ist zumindest die Sensoreinrichtung in Bekleidung der zur schützenden Person integriert.

Auf diese Weise kann einer zur schützenden Person ein Schutz gegen eine Gefährdung ermöglicht werden, welche mit einer möglichst geringen Beeinträchtigung der zur schützenden Person einhergeht, da es somit für zumindest einen wesentlichen Bestandteil der Schutzvorrichtung kein zusätzliches Gehäuse bedarf.

Gemäß einer Ausführungsform der Vorrichtung ist die Sensoreinrichtung an Bekleidung der zur schützenden Person befestigt.

Auf diese Weise kann einer zur schützenden Person ein Schutz gegen eine Gefährdung ermöglicht werden, welche mit einer reduzierten Beeinträchtigung der zur schützenden Person einhergeht, da diese Befestigung eine Funktionalität der Vorrichtung ermöglichen kann, ohne dass es einer erhöhten Aufmerksamkeit der zu schützenden Person bedarf.

Gemäß einer Ausführungsform der Vorrichtung weist die Bekleidung mindestens ein erstes Bekleidungsstück und ein zweites Bekleidungsstück auf, wobei das erste Bekleidungsstück und das zweite Bekleidungsstück miteinander elektrisch koppelbar sind.

Auf diese Weise können einerseits die jeweiligen elektrischen Komponenten jedes Kleidungsstücks mit derselben Energieversorgung gekoppelt werden. Andererseits können auf diese Weise elektrische Signalunterschiede, beispielsweise elektrische Potentialdifferenzen, von Sensoreinrichtungen unterschiedlicher Bekleidungsstücke auf dieselbe Weise ausgelesen und miteinander verglichen werden.

Gemäß einer Ausführungsform der Vorrichtung weist diese eine erste Warnsignaleinrichtung auf, welche zum Ausgeben eines ersten Warnsignals eingerichtet ist, sobald keine elektrische Kopplung zwischen dem ersten Bekleidungsstück und dem zweiten Bekleidungsstück besteht. Gemäß einer Ausführungsform der Vorrichtung weist diese eine zweite Warnsignaleinrichtung auf, welche zum Ausgeben eines zweiten Warnsignals eingerichtet ist, sobald keine elektrische Kopplung zwischen der Sensoreinrichtung und dem ersten Bekleidungsstück und/oder der Sensoreinrichtung und dem zweiten Bekleidungsstück besteht.

Auf diese Weise kann eine Gefährdungssituation aufgrund mangelnder Funktionalität der Vorrichtung einer zu schützenden Person durch ein Warnsignal, beispielsweise ein akustisches Signal, kenntlich gemacht werden. Die zu schützende Person kann hierauf basierend entsprechende Schlussfolgerungen ziehen, beispielsweise eine Unterbrechung ihrer in einer Gefährdungsumgebung stattfinden Tätigkeit und/oder den Austausch der von ihr verwendeten Schutzvorrichtung.

Gemäß einer Ausführungsform der Vorrichtung ist auch die Steuereinrichtung in die Bekleidung der zu schützenden Person integriert.

Auf diese Weise kann einer zur schützenden Person ein zusätzlicher Schutz gegen eine Gefährdung ermöglicht werden, welche mit einer möglichst geringen Beeinträchtigung der zur schützenden Person einhergeht, da es somit für zumindest einen weiteren wesentlichen Bestandteil der Schutzvorrichtung kein zusätzliches Gehäuse bedarf.

Gemäß einer Ausführungsform der Vorrichtung ist die Schalteinrichtung in einem Prüfgerät für eine energietechnische Einrichtung integriert.

Auf diese Weise kann eine möglichst kompakte Bauweise erzielt werden.

Gemäß einer Ausführungsform der Vorrichtung weist die Sensoreinrichtung mindestens einen weiteren Sensor auf, der zum Ermitteln einer Größe eingerichtet ist, die für das auf die Person einwirkende elektrische Signal des elektrisch aktivierbaren Objekts repräsentativ ist, wobei das Annehmen des ersten Betriebszustands oder des zweiten Betriebszustandes durch die Schalteinrichtung ferner auch auf einem Ausgangssignal des mindestens einen weiteren Sensors basiert. Gemäß einer Ausführungsform der Vorrichtung ist der mindestens eine Sensor an einer ersten Position der zu schützenden Person anbringbar und der mindestens eine weitere Sensor ist an einer zweiten Position der zu schützenden Person anbringbar, wobei zwischen der ersten und zweiten Position eine elektrische Spannungsmessung an der zu schützenden Person durchführbar ist.

Auf diese Wiese können elektrische Signalunterschiede, beispielsweise elektrische Potentialdifferenzen, von mehreren Sensoren ermittelt und miteinander verglichen werden. Sofern die Sensoren zur Ermittlung elektrischer Potentiale eingerichtet sind, können auf diese Weise ferner zwischen verschiedenen Körperregionen der zu schützenden Person bestehende elektrische Spannungen ermittelt werden, wodurch das Vorliegen einer Gefährdungssituation bestimmt werden kann.

Gemäß einer Ausführungsform der Vorrichtung entsprechen die erste und zweite Position unterschiedlichen oder identischen Körperextremitäten der zu schützenden Person.

Auf diese Weise kann dem Aspekt Rechnung getragen werden, dass insbesondere für Körperextremitäten wie Arme oder Beine der zur schützenden Person die Gefahr besteht, mit einem elektrisch aktivierbaren Objekt in Kontakt zu geraten. Die Sensoranordnung gemäß dieser Ausführungsform ist somit dazu eingerichtet, hiermit einhergehende elektrische Signale unmittelbar zu detektieren und hierauf basierend eine Situation als Gefährdungslage wahrzunehmen.

Gemäß einer Ausführungsform des Verfahrens wird das Verfahren mit einer gemäß einer Ausführungsform ausgebildeten Vorrichtung durchgeführt.

Auf diese Weise wird ermöglicht, das Verfahren mit einer auf das Verfahren ideal abgestimmten Vorrichtung durchzuführen.

Unter einer energietechnischen Einrichtung gemäß einer Ausführungsform kann eine Einrichtung verstanden werden, welche die Handhabung von Energie mit technischen Mitteln bezweckt. Die Handhabung von Energie kann sich auf elektrische Energie beziehen und mit dem Vorliegen elektrischer Spannungen einhergehen. Die Handhabung von Energie kann sich auf Energietransport beziehen. Der Energietransport kann elektrische Leitungen, beispielsweise Hochspannungsleitungen, vorsehen.

Unter einem biometrischen Sensor gemäß einer Ausführungsform kann Objekt zur Ermittlung von Signalen eines Lebewesens verstanden werden. Die zu ermittelnden Signale können elektrische Signale, beispielsweise Ströme, Spannungen und Impedanzen sein. Die Signalermittlung kann sich auf Signale beziehen, welche einer menschlichen Person zuzuordnenden sind.

Unter einer drahtlosen Verbindung gemäß einer Ausführungsform kann eine Wechselwirkung zweier Objekte verstanden werden, welche eine leitfähige Verbindung dieser beiden Objekte nicht erfordert. Diese Wechselwirkung kann auf elektromagnetische Wellen basieren. Die Wechselwirkung kann eine Funkverbindung sein. Die Wechselwirkung kann zur Signalübertragung eingerichtet sein.

Unter einer Körperextremität gemäß einer Ausführungsform kann ein bei einem Lebewesen durch Muskeln bewegter Körperabschnitt verstanden werden. Der Körperabschnitt kann sich auf eine menschliche Person beziehen. Der Körperabschnitt kann ein Körperglied sein und/oder einen Arm oder ein Bein und/oder den Kopf einer Person betreffen.

In einer weiteren Ausführungsform ist es für die Vorrichtung möglich, zumindest einen dritten Betriebszustand anzunehmen, wobei beim zweiten Betriebszustand Teile des elektrisch aktivierbaren Objekts deaktiviert werden und beim dritten Betriebszustand mindestens ein weiterer Teil oder das gesamte aktivierbare Objekt deaktiviert wird. Es kann der zweite Betriebszustand angenommen werden, wenn zumindest ein Sensor zumindest einer zu schützenden Person eine ungewünschte elektrische Einwirkung auf die zu schützende Person detektiert. Eine zusätzliche Zeitmesseinrichtung kann beim Annehmen des zweiten Betriebszustandes gestartet werden. Wenn der zumindest eine Sensor der zumindest einen zu schützenden Person nach Ablauf einer Zeit, die beispielsweise in der Größenordnung von 50 ms sein kann, nach wie vor eine ungewollte oder unzulässige elektrische Einwirkung auf die zu schützende Person detektiert, kann die Vorrichtung den dritten Betriebszustand annehmen, bei dem ein weiterer Teil oder das gesamte aktivierbare Objekt deaktiviert wird.

Beispielsweise könnte das elektrisch aktivierbare Objekt Teil eines Gebäudes sein, in dem elektrische Geräte geprüft werden. In dem zweiten Betriebszustand könnte somit über ein Not-Aus System des Gebäudes die Spannungsversorgung im Prüffeld des Gebäudes deaktiviert werden.

Würde eine Person mit erfindungsgemäßer Ausrüstung eine spannungsführende Komponente berühren und in der Folge von Strom durchflossen werden, könnte in dem zweiten Betriebszustand das Prüffeld über das Not-Aus-System deaktiviert werden. Würde der Sensor weiter Stromfluss durch die zu schützende Person detektieren, könnte in dem dritten Betriebszustand schließlich das gesamte Gebäude spannungslos geschalten werden.

Eine Person könnte innerhalb der bezüglich des dritten Betriebszustands überwachten Zeit, die bei diesem Ausführungsbeispiel beispielsweise auch in der Größenordnung von mehreren Sekunden (z.B. 10 s) sein könnte, durch eine geeignete Einrichtung auch das Eintreten in den dritten Betriebszustand blockieren, beispielsweise um Fehlauslösungen zu unterbinden.

Obige sowie weitere Vorteile, Merkmale und Anwendungsmöglichkeiten einer Ausführungsform ergeben sich aus der nachfolgenden Beschreibung von bevorzugten Ausführungsbeispielen anhand von wenigstens teilweise schematische Figuren.

In Figur 1 ist die Vorrichtung gemäß einer Ausführungsform, in welcher sie von der zu schützenden Person getragen wird, sowie in vergrößerter Ansicht und in Verbindung mit dem elektrisch aktivierbaren Objekt, schematisch dargestellt.

In Figur 2 ist die Vorrichtung gemäß einer weiteren Ausführungsform, in welcher sie von der zu schützenden Person getragen wird, sowie in vergrößerter Ansicht und in Verbindung mit dem elektrisch aktivierbaren Objekt, schematisch dargestellt.

In Figur 3 ist die Vorrichtung gemäß einer weiteren Ausführungsform, in welcher sie an Bekleidung der zu schützenden Person angebracht ist, schematisch dargestellt.

In Figur 4 ist die Vorrichtung gemäß einer weiteren Ausführungsform, in welcher sie an mehreren Bekleidungsstücken einer Bekleidung der zu schützenden Person angebracht ist, schematisch dargestellt.

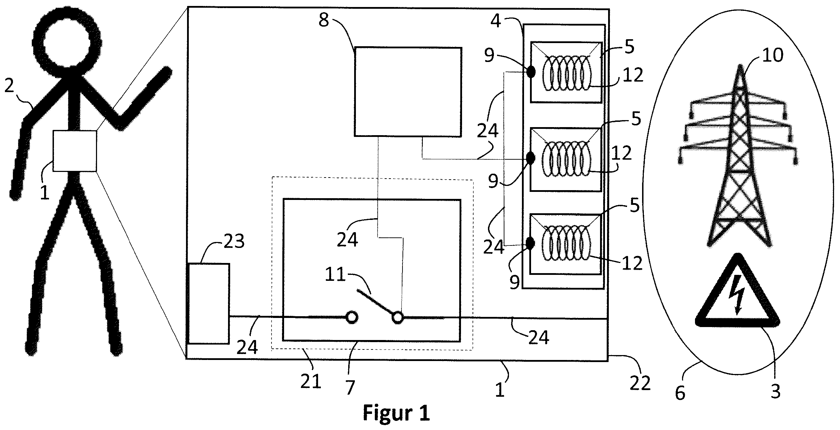

Bezug nehmend auf Figur 1 ist die Vorrichtung 1 gemäß einer Ausführungsform, in welcher sie von der zu schützenden Person 2 getragen wird, sowie in vergrößerter Ansicht und in Verbindung mit dem elektrisch aktivierbaren Objekt 6, schematisch dargestellt. Bezogen auf die linke Seite der in Figur 1 dargestellten Ausführungsform kann die Vorrichtung 1 dabei an der zu schützenden Person 2 angebracht sein. Ein derartiges Anbringen der Vorrichtung 1 an der zu schützenden Person 2 kann beispielsweise durch Fixation mittels gebräuchlicher Fixationsmitteln an der schützenden Person 2 erfolgen. Es sei darauf hingewiesen, dass die Darstellung in der Zeichnung rein schematischer Natur ist und nicht sämtliche Komponenten der Vorrichtung 1 tragbar ausgestaltet oder sich an der Person 2 befinden müssen. Insbesondere die nachfolgend näher erläuterte Schalteinrichtung 7 wird bei der bevorzugten Ausführungsform nicht unmittelbar am Körper der zu schützenden Person 2 getragen.

Wie auf der rechten Seite der in Figur 1 dargestellten Ausführungsform kenntlich gemacht, kann sich die zu schützende Person 2 in unmittelbarer Umgebung zu dem elektrisch aktivierbaren Objekt 6 aufhalten. Ein derartiges elektrisch aktivierbares Objekt kann beispielsweise eine energietechnische Einrichtung 10 und/oder eine Schalteinrichtung sein, welche bei Inbetriebnahme elektrische Signale 3 bereitstellen kann. Derartige elektrische Signale 3 können beispielsweise Hochspannungssignale sein.

Gemäß der in Figur 1 dargestellten Ausführungsform ist im Zentrum der Darstellung die Vorrichtung 1, welche an der zu schützenden Person 2 angebracht ist, in vergrößerter Ansicht dargestellt. Hiernach kann die Vorrichtung 1 eine Kontaktfläche 22 aufweisen, welche dem elektrisch aktivierbaren Objekt zugewandt sein kann. Dabei kann die zu schützende Person 2, an welcher die Vorrichtung 1 angebracht ist, bei der Ausübung ihrer Tätigkeit in der Umgebung des elektrisch aktivierbaren Objekts durch die Kontaktfläche der Vorrichtung 22 mit dem elektrisch aktivierbaren Objekt 6 in Kontakt geraten. Ein derartiger Kontakt mit dem elektrisch aktivierbaren Objekt 6 kann unbeabsichtigt erfolgen, beispielsweise bei einer unkoordinierten und/oder unüberlegten Körperbewegung der zu schützenden Person 2.

Gemäß der in der Bildmitte von Figur 1 dargestellten Ausführungsform kann die Vorrichtung 1 eine Sensoreinrichtung 4 aufweisen. Die Sensoreinrichtung 4 kann einen, zwei, oder eine beliebige Vielzahl an Sensoren 5 aufweisen. Dabei können die Sensoren 5 der Sensoreinrichtung 4 auf der der Kontaktfläche der Vorrichtung 22 zugewandte Seiten der Vorrichtung 1 angebracht sein. Gemäß einer weiteren, nicht dargestellten Ausgestaltung können die Sensoren 5 als biometrische Sensoren 5 ausgestaltet sein und derart angeordnet sein, dass sie imstande sind, eine biometrische Größe der zu schützenden Person 2, beispielsweise den Pulsschlag der zu schützenden Person 2, in Abhängigkeit von dem auf die zu schützende Person 2 einwirkenden elektrischen Signal 3 ermitteln zu können.

Mindestens einer der Sensoren 5 kann dabei eine Rogowski-Spule 12 aufweisen. Gemäß der in Figur 1 dargestellten Ausführungsform weist jeder der drei dargestellten Sensoren 5 eine Rogowski-Spule 12 auf. Es kann jedoch auch vorgesehen sein, dass nicht jeder der Sensoren 5 eine Rogowski-Spule 12 aufweist. Beispielsweise kann lediglich einer der Sensoren 5, zwei der Sensoren 5 oder sogar keiner der Sensoren 5 eine Rogowski-Spule 12 aufweisen. Auch kann vorgesehen sein, dass zumindest einer der Sensoren 5 sogar zwei Rogowski-Spulen 12 oder eine beliebige Vielzahl an Rogowski-Spulen 12 aufweist. Gemäß der in Figur 1 dargestellten Ausführungsform kann eine gewöhnliche, dem Stand der Technik entsprechende Aufnahme der Rogowski-Spule 12 in dem Sensor 5 vorgesehen sein. In diesem Zusammenhang kann die Verwendung von mindestens einer Rogowski-Spule 12 eine besonders robuste Ermittlung hoher elektrischer Signale 3 ermöglichen.

Erfolgt ein mechanischer Kontakt zwischen dem elektrisch aktivierbaren Objekt 6 und der Kontaktfläche der Vorrichtung 22, so kann mindestens einer der Sensoren 5 dazu eingerichtet sein zu erkennen, ob sich das elektrisch aktivierbare Objekt 6 in einem elektrisch aktivierten Zustand befindet. Auch kann vorgesehen sein, dass zwei Sensoren 5, eine beliebige Vielzahl an Sensoren 5 und/oder alle Sensoren 5 dazu eingerichtet sind zu erkennen, ob sich das elektrisch aktivierbare Objekt 6 in einem elektrisch aktivierten Zustand befindet. Auch kann vorgesehen sein, dass mindestens einer der Sensoren 5 nicht nur in einem mechanischen Kontakt mit dem elektrisch aktivierbaren Objekt 6, sondern auch in kurzer Distanz zu dem elektrisch aktivierbaren Objekt 6 erkennen kann, dass sich das elektrisch aktivierbaren Objekt 6 in dem aktivierten Zustand befindet. Der aktivierte Zustand des elektrisch aktivierbaren Objekt 6 kann mit der Bereitstellung des elektrischen Signals 3 durch das elektrisch aktivierbaren Objekt 6 einhergehen, welches gemäß der in Figur 1 dargestellten Ausführungsform von mindestens einem der Sensoren 5 ermittelt werden kann. Dabei kann das elektrische Signal 3 einem elektrischen Hochspannungssignal und/oder einem sehr hohe elektrische Ströme aufweisenden elektrischen Signal entsprechen.

Gemäß der in Figur 1 dargestellten Ausführungsform kann ferner vorgesehen sein, dass bei Kontakt zwischen dem elektrisch aktivierbaren Objekt 6 und der Kontaktfläche der Vorrichtung 22 durch einen Sensor 5, zwei Sensoren 5 oder eine beliebige Vielzahl an Sensoren 5 ein Ausgangssignal 9 des jeweiligen Sensors 5 bereitgestellt werden kann, welches Informationen dahingehend aufweisen kann, ob das elektrisch aktivierbaren Objekt 6 sich in einem aktivierten Zustand befindet, welcher mit dem Übertrag des elektrischen Signals 3 von dem elektrisch aktivierbaren Objekt 6 auf die Kontaktfläche der Vorrichtung 22 einhergehen kann. Dabei können die Ausgangssignale 9 der Sensoren 5 über eine beliebige Anzahl an elektrischen Leitungen 24 einer Steuereinrichtung 8, welche in der Vorrichtung 1 aufgenommen ist, zugeführt werden.

Gemäß der in Figur 1 dargestellten Ausführungsform kann die Steuereinrichtung 8 dazu eingerichtet sein zu erkennen, ob durch das elektrisch aktivierbaren Objekt 6 das elektrische Signal 3 auf die Kontaktfläche der Vorrichtung 22 übertragen worden ist. Auf diese Weise kann durch die Steuereinrichtung 8 ermittelt werden, ob sich das elektrisch aktivierbare Objekt 6 in einem aktivierten Zustand befindet und mit der Kontaktfläche 22 der Vorrichtung 1 in direktem Kontakt steht.

Basierend auf dieser durch die Steuereinrichtung 8 getätigten Ermittlung kann über die elektrische Leitung 24 eine entsprechende Information an die Schalteinrichtung 7, welche in einem Prüfgerät 21 für die Schalteinrichtung aufgenommen sein kann, übermittelt werden. Die Schalteinrichtung 7 kann somit gesteuert durch die Steuereinrichtung 8 selektiv einen ersten Betriebszustand und einen zweien Betriebszustand, welcher sich von dem ersten Betriebszustand unterscheidet, annehmen. Die Schalteinrichtung 7 ist jedoch nicht hierauf beschränkt. Vielmehr kann auch vorgesehen sein, dass die Schalteinrichtung 7 weitere Betriebszustände gesteuert oder ungesteuert von der Steuereinrichtung 8 annehmen kann.

Gemäß der in Figur 1 dargestellten Ausführungsform ist das Annehmen des ersten Betriebszustandes durch die Schalteinrichtung 7 vorgesehen, sofern kein elektrisches Signal 3 des elektrisch aktivierbaren Objekts 6 auf die Kontaktfläche der Vorrichtung 22 übertragen wird. Die Schalteinrichtung 7 kann in diesem Fall die Übertragung von elektrischen Signalen über die Schalteinrichtung 7 auf einen Berührungspunkt der Person 23 ermöglichen, welcher mit der zu schützenden Person 2 leitend in Verbindung stehen kann. Gemäß der in Figur 1 dargestellten Ausführungsform ist das Annehmen des zweiten Betriebszustandes durch die Schalteinrichtung 7 vorgesehen, sofern ein elektrisches Signal 3 des elektrisch aktivierbaren Objekts 6, welches sich in dem aktivierten Zustand befindet, auf die Kontaktfläche der Vorrichtung 22 übertragen wird und von mindestens einem der Sensoren 5 erkannt wird. Die Schalteinrichtung 7, welche von der Steuereinrichtung 8 gesteuert wird, kann in diesem Fall die Übertragung von elektrischen Signalen über die Schalteinrichtung 7 auf den Berührungspunkt der Person 23, welcher mit der zu schützenden Person 2 leitend in Verbindung stehen kann, verhindern, wodurch die zu schützende Person 2 vor Gefahren der elektrischen Signale 3 des elektrisch aktivierbaren Objekts 6 geschützt werden kann.

Zur Vermeidung der Übertragung von elektrischen Signalen über die Schalteinrichtung 7 auf den Berührungspunkt der Person 23 kann gemäß der in Figur 1 dargestellten Ausführungsform ein Unterbrechen der elektrischen Verbindung 11 vorgesehen sein. Ein derartiges Unterbrechen der elektrischen Verbindung 11 kann beispielsweise unter Verwendung mindestens eines gewöhnlichen Schaltelements, beispielsweise eines Schalters oder eines anderen Elements, welches eine gewünschte Trennen der elektrischen Verbindung 11 herbeiführen kann, erfolgen. Diese Ausführungsform ist jedoch nicht auf einen derartigen Mechanismus limitiert. Vielmehr kann auch vorgesehen sein, dass eine Vermeidung der Übertragung von elektrischen Signalen über die Schalteinrichtung 7 auf den Berührungspunkt der Person 23 in dem zweiten Betriebszustand durch ein elektrisches Kurzschließen durch die Schalteinrichtung 7 erfolgt (nicht dargestellt). Auch weitere, nicht dargestellte, jedoch zur Vermeidung der Übertragung von elektrischen Signalen über die Schalteinrichtung 7 auf den Berührungspunkt 23 der zu schützenden Person 2 geeignete Mechanismen sind gemäß dieser Ausführungsform vorgesehen.

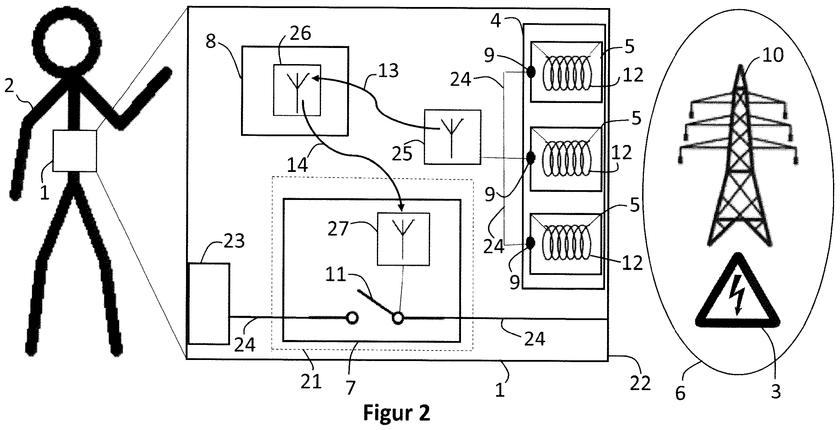

Bezug nehmend auf Figur 2 ist die Vorrichtung 1 gemäß einer weiteren Ausführungsform, in welcher sie von der zu schützenden Person 2 getragen wird, sowie in vergrößerter Ansicht und in Verbindung mit dem elektrisch aktivierbaren Objekt 6, schematisch dargestellt. Gegenüber der in Figur 1 dargestellten Ausführungsform unterscheidet sich die in Figur 2 dargestellte weitere Ausführungsformen insbesondere dahingehend, dass diese keine elektrischen Leitungen 24 vorsieht, welche die Sensoreinrichtung 4 mit der Steuereinrichtung 8 und die Steuereinrichtung 8 mit der Schalteinrichtung 7 leitend verbindet. Diese weitere Ausführungsform ist jedoch nicht auf die Darstellungen gemäß den Figuren 1 und 2 beschränkt. Vielmehr kann gemäß weiterer Ausführungsformen auch vorgesehen sein, dass lediglich die elektrische Leitung 24 zwischen der Sensoreinrichtung 4 und der Steuereinrichtung 8 aus Figur 1 existiert oder lediglich die elektrische Leitung 24 zwischen der Steuereinrichtung 8 und der Schalteinrichtung 7 aus Figur 1 existiert.

Gemäß der Darstellung nach Figur 2 erfolgt die Signalübertragung zwischen der Sensoreinrichtung 4 und der Steuereinrichtung 8 auf Basis einer ersten drahtlosen Verbindung 13 zwischen der ersten Antenneneinrichtung 25 und der zweiten Antenneneinrichtung 26. Dabei können die erste Antenneneinrichtung 25 und die zweite Antenneneinrichtung 26 in der Sensoreinrichtung 4 beziehungsweise der Steuereinrichtung 8 aufgenommen sein oder mit der jeweiligen Einrichtung leitend verbunden sein. Die erste drahtlose Verbindung 13 kann zur Übertragung von elektromagnetischen Wellen eingerichtet sein. Die erste drahtlose Verbindung 13 kann ferner als Funkverbindung eingerichtet sein. Die Vorrichtung 1 kann ferner derart eingerichtet sein, dass im Falle einer Störung der ersten drahtlosen Verbindung 13 die Schalteinrichtung 7 den zweiten Betriebszustand annimmt.

Gemäß der Darstellung nach Figur 2 erfolgt die Signalübertragung zwischen der der Steuereinrichtung 8 und der Schalteinrichtung 7 auf Basis einer zweiten drahtlosen Verbindung 14 zwischen der zweiten Antenneneinrichtung 26 und der dritten Antenneneinrichtung 27. Dabei können die zweite Antenneneinrichtung 26 und die dritte Antenneneinrichtung 27 in der Steuereinrichtung 8 beziehungsweise der Schalteinrichtung 7 aufgenommen sein oder mit der jeweiligen Einrichtung leitend verbunden sein. Die zweite drahtlose Verbindung 14 kann zur Übertragung von elektromagnetischen Wellen eingerichtet sein. Die zweite drahtlose Verbindung 14 kann ferner als Funkverbindung eingerichtet sein. Die Vorrichtung 1 kann ferner derart eingerichtet sein, dass im Falle einer Störung der zweiten drahtlosen Verbindung 14 die Schalteinrichtung 7 den zweiten Betriebszustand annimmt.

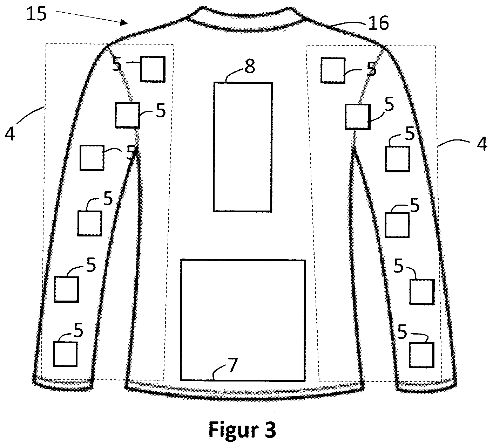

Bezug nehmend auf Figur 3 ist die Vorrichtung 1 gemäß einer weiteren Ausführungsform, in welcher sie an Bekleidung 15 der zu schützenden Person 2 angebracht ist, schematisch dargestellt. Gemäß dieser Ausführungsform ist die Vorrichtung 1 an einem ersten Bekleidungsstück 16 der Bekleidung 15 angebracht. Die Vorrichtung 1 gemäß dieser Ausführungsform weist eine Sensoreinrichtung 4, aufweisend eine Vielzahl an Sensoren 5, auf. Es kann vorgesehen sein, dass die Anordnung der Sensoren 5 vornehmlich oder ausschließlich in Bereichen des ersten Bekleidungsstück 16 vorgesehen ist, welche vornehmlich zur Bedeckung von Extremitäten, beispielsweise Hände und/oder Arme und/oder Schulterblatt, der zu schützenden Person 2 vorgesehen sind. Es kann dabei vorgesehen sein, dass die Sensoreinrichtung 4 in der Bekleidung 15 der zu schützenden Person 2 integriert oder mittels geeigneter Fixationsmittel an der Bekleidung 15 der zu schützenden Person 2 befestigt ist.

Gemäß der in Figur 3 dargestellten Ausführungsform kann ferner die Steuereinrichtung 8 und die Schalteinrichtung 7 an dem ersten Bekleidungsstück 16 der Bekleidung 15 angebracht sein. Dabei kann die Steuereinrichtung 8 in dem Bekleidungsstück 16 der Bekleidung 15 integriert sein oder mittels geeigneter Fixationsmittel an dieser befestigt sein. Ferner kann die Schalteinrichtung 7 in dem Bekleidungsstück 16 der Bekleidung 15 integriert sein oder mittels geeigneter Fixationsmittel an dieser befestigt sein. Gemäß der in Figur 3 dargestellten Ausführungsform sind die Steuereinrichtung 8 und die Schalteinrichtung 7 derart an der Bekleidung 15 angeordnet, dass sie zur Anordnung im Rumpfbereich der zu schützenden Person 2 vorgesehen sein können. Es kann jedoch auch vorgesehen sein, dass die Steuervorrichtung 8 und/oder die Schaltvorrichtung 7 an jeder anderen, beliebigen Körperregion zur Anordnung eingerichtet sind.

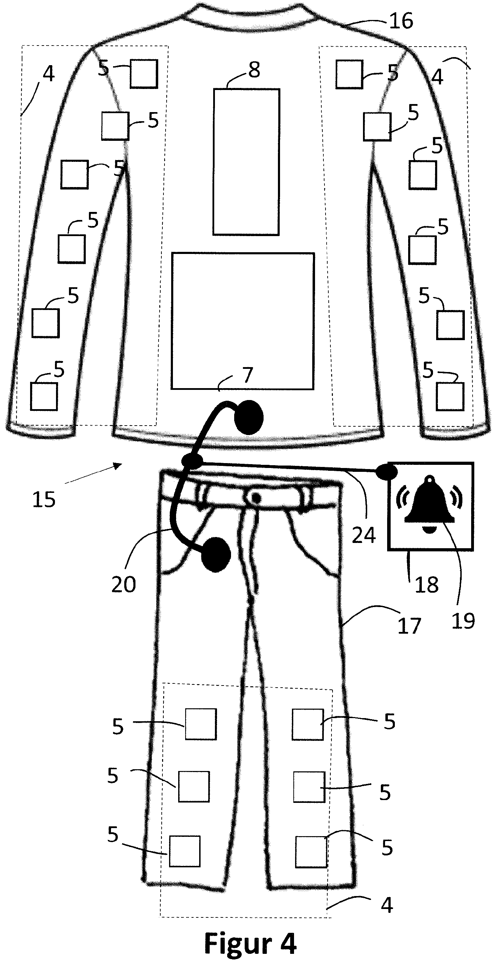

Bezug nehmend auf Figur 4 ist die Vorrichtung 1 gemäß einer weiteren Ausführungsform, in welcher sie an mehreren Bekleidungsstücken 16, 17 einer Bekleidung 15 der zu schützenden Person angebracht ist, schematisch dargestellt. Gemäß der in Figur 3 dargestellten Ausführungsform kann die Vorrichtung 1 eine Vielzahl an Sensoreinrichtungen 4, aufweisend jeweils eine Vielzahl an Sensoren 5, aufweisen. Dabei können die jeweiligen Komponenten der Vorrichtung 1 an der Bekleidung 15, aufweisend ein erstes Bekleidungsstück 16 und ein zweites Bekleidungsstück 17, angebracht sein. Dabei kann das erste Bekleidungsstück 16 oder das zweite Bekleidungsstück 17 zur Bedeckung des Oberkörpers der zur schützenden Person 2 eingerichtet sein. Ferner kann das erste Bekleidungsstück 16 oder das zweite Bekleidungsstück 17 zur Bedeckung des Unterkörpers der zur schützenden Person 2 eingerichtet sein und beispielsweise als Hose ausgestaltet sein. Die Steuereinrichtung 8 und/oder die Schalteinrichtung 7 können an dem ersten Bekleidungsstück 16 und/oder dem zweiten Bekleidungsstück 17 der Bekleidung 15 angebracht sein.

Gemäß der in Figur 4 dargestellten Ausführungsform können das erste Bekleidungsstück 16 und das zweite Bekleidungsstück 17 miteinander elektrisch gekoppelt sein, wobei zur Ermöglichung einer derartigen elektrischen Kopplung 20 jedes gebräuchliche Kopplungsglied vorgesehen ist. Es kann vorgesehen sein, dass das Vorliegen einer störungsfreien Kopplung fortwährend oder in regelmäßigen Abständen durch eine erste Warnsignaleinrichtung 18 geprüft werden kann, wobei die erste Warnsignaleinrichtung 18 zum Ausgeben eines entsprechenden Warnsignals 19 eingerichtet sein kann. Die erste Warnsignaleinrichtung 18 kann über eine elektrische Leitung 24 mit der elektrischen Kopplung 20 verbunden sein. Als Warnsignal 19 kann ein akustisches oder visuelles Warnsignal 19 vorgesehen sein.

Gemäß dieser Aufführungsform kann ferner auch eine zweite Warnsignaleinrichtung (nicht dargestellt) vorgesehen sein, die zur Prüfung einer elektrischen Kopplung zwischen der Sensoreinrichtung 4 und dem ersten Bekleidungsstück 16 und/oder der Sensoreinrichtung 4 und dem zweiten Bekleidungsstück 17 eingerichtet ist. Die zweite Warnsignaleinrichtung kann bei einer Störung der elektrischen Kopplung ein zweites Warnsignal ausgeben. Das zweite Warnsignal kann ein akustisches oder visuelles Warnsignal sein.

**Bezugszeichenliste**

| | |
|---|---|
| Vorrichtung | 1 |
| Person | 2 |
| Elektrisches Signal | 3 |
| Sensoreinrichtung | 4 |
| Sensor | 5 |
| Elektrisch aktivierbares Objekt | 6 |
| Schalteinrichtung | 7 |
| Steuereinrichtung | 8 |
| Ausgangssignal | 9 |
| Energietechnische Einrichtung | 10 |
| Elektrische Verbindung | 11 |
| Rogowski-Spule | 12 |
| Erste drahtlose Verbindung | 13 |
| Zweite drahtlose Verbindung | 14 |
| Bekleidung | 15 |
| Erstes Bekleidungsstück | 16 |
| Zweites Bekleidungsstück | 17 |
| Erste Warnsignaleinrichtung | 18 |
| Erstes Warnsignal | 19 |
| Elektrische Kopplung | 20 |
| Prüfgerät | 21 |
| Kontaktfläche der Vorrichtung | 22 |
| Berührungspunkt der Person | 23 |
| Elektrische Leitungen | 24 |
| Erste Antenneneinrichtung | 25 |
| Zweite Antenneneinrichtung | 26 |
| Dritte Antenneneinrichtung | 27 |

## Patentansprüche

1. Vorrichtung (1) zum Schutz einer Person (2) vor einem elektrischen Signal (3), aufweisend:
eine von der zu schützenden Person (2) tragbare Sensoreinrichtung (4), welche mindestens einen Sensor (5) aufweist, der zum Ermitteln einer Größe eingerichtet ist, die für ein auf die Person (2) einwirkendes elektrisches Signal (3) eines elektrisch aktivierbaren Objekts (6) repräsentativ ist,
eine Schalteinrichtung (7), welche zum Annehmen mindestens eines ersten Betriebszustandes und eines zweiten Betriebszustandes eingerichtet ist, wobei der erste Betriebszustand die Übertragung des elektrischen Signals (3) des elektrisch aktivierbaren Objekts (6) auf die zu schützende Person (2) ermöglicht und der zweite Betriebszustand die Übertragung des elektrischen Signals (3) des elektrisch aktivierbaren Objekts (6) auf die zu schützende Person (2) nicht ermöglicht, und
eine Steuereinrichtung (8), welche basierend auf einem Ausgangssignal (9) des mindestens einen Sensors (5) die Schalteinrichtung (7) ansteuert, so dass die Schalteinrichtung (7) abhängig von dem Ausgangssignal (9) des mindestens einen Sensors (5) selektiv den ersten Betriebszustand oder den zweiten Betriebszustand annimmt,
**dadurch gekennzeichnet,**
**dass** der mindestens eine Sensor (5) ein biometrischer Sensor (5) zum Ermitteln einer biometrischen Größe der zu schützenden Person (2) in Abhängigkeit von dem auf die Person (2) einwirkenden elektrischen Signal (3) ist.

2. Vorrichtung (1) nach Anspruch 1, wobei die Vorrichtung (1) derart ausgestaltet ist, dass in dem zweiten Betriebszustand ein elektrisches Kurzschließen oder ein Unterbrechen einer elektrischen Verbindung (11) durch die Schalteinrichtung (7) erfolgt, um die Übertragung des elektrischen Signals (3) auf die zu schützende Person (2) zu unterbinden.

3. Vorrichtung (1) nach einem der vorhergehenden Ansprüche, wobei die zu ermittelnde biometrische Größe den Pulsschlag der zu schützenden Person (2) beinhaltet.

4. Vorrichtung (1) nach einem der vorhergehenden Ansprüche, welche eine drahtlose Verbindung (13, 14) zwischen dem mindestens einen Sensor (5) und der Steuereinrichtung (8) und/oder zwischen der Steuereinrichtung (8) und der Schalteinrichtung (7) ermöglicht.

5. Vorrichtung (1) nach Anspruch 4, wobei die Vorrichtung dazu eingerichtet ist, im Falle einer Störung der drahtlosen Verbindung (13, 14) eine Warnung auszugeben.

6. Vorrichtung (1) nach Anspruch 4 oder Anspruch 5, wobei die Vorrichtung (1) dazu eingerichtet ist, dass die Schalteinrichtung (7) im Falle einer Störung der drahtlosen Verbindung (13, 14) den zweiten Betriebszustand annimmt.

7. Vorrichtung (1) nach einem der vorhergehenden Ansprüche, wobei die Sensoreinrichtung (4) in einer Bekleidung (15) der zur schützenden Person (2) integriert oder an der Bekleidung (15) befestigt ist.

8. Vorrichtung (1) nach Anspruch 7, wobei die Bekleidung (15) mindestens ein erstes Bekleidungsstück (16) und ein zweites Bekleidungsstück (17) aufweist, wobei das erste Bekleidungsstück (16) und das zweite Bekleidungsstück (17) miteinander elektrisch koppelbar sind.

9. Vorrichtung (1) nach Anspruch 8, aufweisend eine Warnsignaleinrichtung (18), welche zum Ausgeben eines Warnsignals (19) eingerichtet ist, sobald keine elektrische Kopplung (20) zwischen dem ersten Bekleidungsstück (16) und dem zweiten Bekleidungsstück (17) oder keine elektrische Kopplung (20) zwischen der Sensoreinrichtung (4) und dem ersten Bekleidungsstück (16) und/oder der Sensoreinrichtung (4) und dem zweiten Bekleidungsstück (17) besteht.

10. Vorrichtung (1) nach einem der Ansprüche 7 bis 9, wobei auch die Steuereinrichtung (8) in die Bekleidung (15) der zu schützenden Person (2) integriert ist.

11. Vorrichtung (1) nach einem der vorhergehenden Ansprüche, wobei die Schalteinrichtung (7) in ein Prüfgerät (21) für eine energietechnische Einrichtung (10) integriert ist.

12. Vorrichtung (1) nach einem der vorhergehenden Ansprüche,
wobei die Sensoreinrichtung (4) mindestens einen weiteren Sensor (5) aufweist, der zum Ermitteln einer Größe eingerichtet ist, die für das auf die Person (2) einwirkende elektrische Signal (3) des elektrisch aktivierbaren Objekts (6) repräsentativ ist, wobei das Annehmen des ersten Betriebszustands oder des zweiten Betriebszustandes durch die Schalteinrichtung (7) ferner auch auf einem Ausgangssignal (9) des mindestens einen weiteren Sensors (5) basiert, und
wobei der mindestens eine Sensor (5) an einer ersten Position der zu schützenden Person (2) anbringbar ist und der mindestens eine weitere Sensor (5) an einer zweiten Position der zu schützenden Person (2) anbringbar sind, wobei zwischen der ersten und zweiten Position eine elektrische Spannungsmessung an der zu schützenden Person (2) durchführbar ist.

13. Vorrichtung nach einem der vorhergehenden Ansprüche,
wobei mindestens ein dritter Betriebszustand vorgesehen ist und die Vorrichtung eine Zeitmesseinrichtung umfasst, wobei in dem zweiten Betriebszustand ein Teil des elektrisch aktivierbaren Objekts deaktiviert wird und nach Ablauf einer von der Zeitmesseinrichtung erfassten Zeitspanne abhängig von dem Ausgangssignal des mindestens einen Sensors der dritte Betriebszustand angenommen wird,
wobei in dem dritten Betriebszustand mindestens ein weiterer Teil des elektrisch aktivierbaren Objekts deaktiviert wird, und
wobei die Vorrichtung vorzugsweise eine Komponente umfasst, über die der Eintritt in den dritten Betriebszustand blockiert werden kann.

14. Verwendung einer Vorrichtung nach einem der vorhergehenden Ansprüche zum Schutz einer Person (2) vor einem elektrischen Signal (3) einer Komponente einer energietechnischen Einrichtung (10), insbesondere einer Schaltanlage, als das elektrisch aktivierbare Objekt (6).

15. Verfahren zum Schutz einer Person (2) vor einem elektrischen Signal (3), aufweisend die folgenden Schritte:
Ermitteln einer Größe, die für ein auf die zu schützende Person (2) einwirkendes elektrisches Signal (3) eines elektrisch aktivierbaren Objekts (6) repräsentativ ist, mit Hilfe mindestens eines Sensors (5) einer von der zu schützenden Person (2) getragenen Sensoreinrichtung (4), und
Ansteuern einer Schalteinrichtung (7) mit Hilfe einer Steuereinrichtung (8) basierend auf einem Ausgangssignal (9) des mindestens einen Sensors (5) derart, dass die Schalteinrichtung (7) abhängig von dem Ausgangssignal (9) des mindestens einen Sensors (5) selektiv einen ersten Betriebszustand oder einen zweiten Betriebszustand annimmt, wobei der erste Betriebszustand die Übertragung des elektrischen Signals (3) des elektrisch aktivierbaren Objekts (6) auf die zu schützende Person (2) ermöglicht und der zweite Betriebszustand die Übertragung des elektrischen Signals (3) des elektrisch aktivierbaren Objekts (6) auf die zu schützende Person (2) nicht ermöglicht,
**dadurch gekennzeichnet,**
**dass** der mindestens eine Sensor (5) ein biometrischer Sensor (5) zum Ermitteln einer biometrischen Größe der zu schützenden Person (2) in Abhängigkeit von dem auf die Person (2) einwirkenden elektrischen Signal (3) ist.

## Claims

1. A device (1) for protecting a person (2) from an electrical signal (3), comprising:
a sensor device (4) wearable by the person (2) to be protected, comprising at least one sensor (5) configured for determining a magnitude representative of an electrical signal (3) of an electrically activatable object (6) acting on the person (2),
a switching device (7) configured for assuming at least a first operating state and a second operating state, the first operating state enabling transmission of the electrical signal (3) of the electrically activatable object (6) to the person (2) to be protected, and the second operating state not enabling transmission of the electrical signal (3) of the electrically activatable object (6) to the person (2) to be protected, and
a control device (8) controlling the switching device (7) based on an output signal (9) of the at least one sensor (5), so that the switching device (7) selectively assumes the first operating state or the second operating state depending on the output signal (9) of the at least one sensor (5),
**characterized in that**
the at least one sensor (5) is a biometric sensor (5) for determining a biometric magnitude of the person (2) to be protected depending on the electrical signal (3) acting on the person (2).

2. The device (1) according to claim 1, wherein the device (1) is configured such that in the second operating state an electrical short-circuiting or an interrupting of an electrical connection (11) by the switching device (7) is performed in order to inhibit the transmission of the electrical signal (3) to the person (2) to be protected.

3. The device (1) according to any one of the preceding claims, wherein the biometric magnitude to be determined includes the pulse rate of the person (2) to be protected.

4. The device (1) according to any one of the preceding claims, which enables a wireless connection (13, 14) between the at least one sensor (5) and the control device (8) and/or between the control device (8) and the switching device (7).

5. The device (1) according to claim 4, wherein the device is configured to output a warning in case of a disturbance of the wireless connection (13, 14).

6. The device (1) according to claim 4 or claim 5, wherein the device (1) is configured such that the switching device (7) assumes the second operating state in case of a disturbance of the wireless connection (13, 14).

7. The device (1) according to any one of the preceding claims, wherein the sensor device (4) is integrated in a clothing (15) of the person (2) to be protected or is attached to the clothing (15).

8. The device (1) according to claim 7, wherein the clothing (15) comprises at least a first piece of clothing (16) and a second piece of clothing (17), wherein the first piece of clothing (16) and the second piece of clothing (17) are electrically couplable to each other.

9. The device (1) according to claim 8, comprising a warning signal device (18) configured for outputting a warning signal (19) as soon as there is no electrical coupling (20) between the first piece of clothing (16) and the second piece of clothing (17) or no electrical coupling (20) between the sensor device (4) and the first piece of clothing (16) and/or the sensor device (4) and the second piece of clothing (17).

10. The device (1) according to any one of claims 7 to 9, wherein the control device (8) is also integrated into the clothing (15) of the person (2) to be protected.

11. The device (1) according to any one of the preceding claims, wherein the switching device (7) is integrated in a test device (21) for an energy technology device (10).

12. The device (1) according to any one of the preceding claims,
wherein the sensor device (4) comprises at least one further sensor (5) configured to determine a magnitude representative of the electrical signal (3) of the electrically activatable object (6) acting on the person (2), wherein assuming the first operating state or the second operating state by the switching device (7) is further also based on an output signal (9) of the at least one further sensor (5), and
wherein the at least one sensor (5) is attachable at a first position of the person (2) to be protected and the at least one further sensor (5) is attachable at a second position of the person (2) to be protected, wherein between the first and the second positions an electrical voltage measurement is performable at the person (2) to be protected.

13. The device according to any one of the preceding claims,
wherein at least a third operating state is provided, and the device comprises a time measuring device, wherein in the second operating state a part of the electrically activatable object is deactivated and after expiry of a time period detected by the time measuring device the third operating state is assumed depending on the output signal of the at least one sensor,
wherein in the third operating state at least one further part of the electrically activatable object is deactivated, and
wherein the device preferably comprises a component via which the entering of the third operating state can be blocked.

14. A use of a device according to any one of the preceding claims for protecting a person (2) from an electrical signal (3) of a component of an energy technology device (10), in particular a switching equipment, as the electrically activatable object (6).

15. A method for protecting a person (2) from an electrical signal (3), comprising the following steps:
determining a magnitude representative of an electrical signal (3) of an electrically activatable object (6) acting on the person (2) to be protected by means of at least one sensor (5) of a sensor device (4) worn by the person (2) to be protected, and
controlling a switching device (7) by means of a control device (8) based on an output signal (9) of the at least one sensor (5) such that the switching device (7) selectively assumes a first operating state or a second operating state depending on the output signal (9) of the at least one sensor (5), wherein the first operating state enables the transmission of the electrical signal (3) of the electrically activatable object (6) to the person (2) to be protected and the second operating state does not enable the transmission of the electrical signal (3) of the electrically activatable object (6) to the person (2) to be protected,
**characterized in that**
the at least one sensor (5) is a biometric sensor (5) for determining a biometric magnitude of the person (2) to be protected depending on the electrical signal (3) acting on the person (2).

## Revendications

1. Dispositif (1) permettant de protéger une personne (2) contre un signal (3) électrique, comprenant :
un appareil de détection (4) pouvant être porté par la personne (2) à protéger et comportant au moins un capteur (5), lequel est conçu pour déterminer une grandeur, laquelle représente un signal (3) électrique, agissant sur la personne (2), d'un objet (6) pouvant être activé électriquement,
un appareil de commutation (7), lequel est conçu pour passer à au moins un premier état de fonctionnement et à un deuxième état de fonctionnement, dans lequel le premier état de fonctionnement permet la transmission du signal (3) électrique de l'objet (6) pouvant être activé électriquement à la personne (2) à protéger et le deuxième état de fonctionnement ne permet pas la transmission du signal (3) électrique de l'objet (6) pouvant être activé électriquement à la personne (2) à protéger, et
un appareil de commande (8), lequel commande l'appareil de commutation (7) sur la abse d'un signal de sortie (9) dudit au moins un capteur (5) de telle sorte que l'appareil de commutation (7) passe sélectivement au premier état de fonctionnement ou au deuxième état de fonctionnement en fonction du signal de sortie (9) dudit au moins un capteur (5),
**caractérisé**
**en ce que** ledit au moins un capteur (5) est un capteur (5) biométrique permettant de déterminer une grandeur biométrique de la personne (2) à protéger en fonction du signal (3) électrique agissant sur la personne (2).

2. Dispositif (1) selon la revendication 1, dans lequel le dispositif (1) est conçu de telle sorte que dans le deuxième état de fonctionnement, un court-circuit électrique ou une connexion (11) électrique est interrompu(e) par l'appareil de commutation (7) afin de transmettre le signal (3) électrique pour prévenir la personne (2) à protéger.

3. Dispositif (1) selon l'une quelconque des revendications précédentes, dans lequel la grandeur biométrique à déterminer contient le pouls de la personne (2) à protéger.

4. Dispositif (1) selon l'une quelconque des revendications précédentes, lequel permet une connexion (13, 14) sans fil entre l'au moins un capteur (5) et l'appareil de commande (8) et/ou entre l'appareil de commande (8) et l'appareil de commutation (7).

5. Dispositif (1) selon la revendication 4, dans lequel le dispositif est conçu pour émettre un avertissement en cas de défaut dans la connexion (13, 14) sans fil.

6. Dispositif (1) selon la revendication 4 ou 5, dans lequel le dispositif (1) est conçu de telle sorte que l'appareil de commutation (7) passe au deuxième état de fonctionnement en cas de défaut dans la connexion (13, 14) sans fil.

7. Dispositif (1) selon l'une quelconque des revendications précédentes, dans lequel l'appareil de détection (4) est intégré à un vêtement (15) de la personne (2) à protéger ou est fixé audit vêtement (15).

8. Dispositif (1) selon la revendication 7, dans lequel le vêtement (15) comprend au moins une première pièce de vêtement (16) et une seconde pièce de vêtement (17), dans lequel la première pièce de vêtement (16) et la seconde pièce de vêtement (17) peuvent être couplées électriquement l'une à l'autre.

9. Dispositif (1) selon la revendication 8, comportant un appareil d'avertissement (18), lequel est conçu pour émettre un signal d'avertissement (19) dès qu'il n'y a pas de couplage (20) électrique entre la première pièce de vêtement (16) et la seconde pièce de vêtement (17) ou qu'il n'y a aucun couplage (20) électrique entre l'appareil de détection (4) et la première pièce de vêtement (16) et/ou entre l'appareil de détection (4) et la ' pièce de vêtement (17).

10. Dispositif (1) selon l'une quelconque des revendications 7 à 9, dans lequel l'appareil de commande (8) est également intégré au vêtement (15) de la personne (2) à protéger.

11. Dispositif (1) selon l'une quelconque des revendications précédentes, dans lequel l'appareil de commutation (7) est intégré dans un appareil d'essai (21) pour un appareil (10) technique énergétique.

12. Dispositif (1) selon l'une quelconque des revendications précédentes,
dans lequel l'appareil de détection (4) comporte au moins un capteur (5) supplémentaire, lequel est conçu pour déterminer une grandeur, laquelle représente le signal (3) électrique de l'objet (6) pouvant être activé électriquement agissant sur la personne (2), dans lequel le passage au premier état de fonctionnement ou au deuxième état de fonctionnement par l'appareil de commutation (7) est également basé sur un signal de sortie (9) de l'au moins un capteur (5) supplémentaire, et
dans lequel l'au moins un capteur (5) peut être placé dans une première position de la personne (2) à protéger et l'au moins un capteur (5) supplémentaire peut être placé dans une seconde position de la personne (2) à protéger, dans lequel une mesure de tension électrique peut être effectuée sur la personne (2) à protéger entre la première et la seconde position.

13. Dispositif selon l'une quelconque des revendications précédentes,
dans lequel au moins un troisième état de fonctionnement est fourni et le dispositif comprend un appareil de mesure du temps, dans lequel, dans le deuxième état de fonctionnement, une partie de l'objet pouvant être activé électriquement est désactivée et, après l'écoulement d'un laps de temps détecté par l'appareil de mesure du temps, le troisième état de fonctionnement est atteint en fonction du signal de sortie de l'au moins un capteur,
dans lequel, dans le troisième état de fonctionnement, au moins une autre partie de l'objet pouvant être activé électriquement est désactivée, et
dans lequel le dispositif comprend, de préférence un composant au moyen duquel le passage au troisième état de fonctionnement peut être bloqué.

14. Utilisation d'un dispositif selon l'une quelconque des revendications précédentes pour protéger une personne (2) contre un signal (3) électrique d'un composant d'un appareil (10) technique énergétique, en particulier d'une installation de commutation, en tant qu'objet (6) pouvant être activé électriquement.

15. Procédé de protection d'une personne (2) contre un signal (3) électrique, comprenant les étapes suivantes :
la détermination d'une grandeur représentant un signal (3) électrique d'un objet (6) pouvant être activé électriquement agissant sur la personne (2) à protéger, à l'aide d'au moins un capteur (5) d'un appareil de détection (4) porté par la personne (2) à protéger, et
la commande d'un appareil de commutation (7) à l'aide d'un appareil de commande (8) sur la base d'un signal de sortie (9) de l'au moins un capteur (5) de telle sorte que l'appareil de commutation (7) passe sélectivement à un premier état de fonctionnement ou à un deuxième état de fonctionnement en fonction du signal de sortie (9) de l'au moins un capteur (5), dans lequel le premier état de fonctionnement permet la transmission du signal (3) électrique de l'objet (6) pouvant être activé électriquement à la personne (2) à protéger et le deuxième état de fonctionnement ne permet pas la transmission du signal (3) électrique de l'objet (6) pouvant être activé électriquement à la personne (2) à protéger,
**caractérisé**
**en ce que** ledit au moins un capteur (5) est un capteur (5) biométrique permettant de déterminer une grandeur biométrique de la personne (2) à protéger en fonction du signal (3) électrique agissant sur la personne (2).
